**Europäisches Patentamt**

**European Patent Office**

**Office européen des brevets**

(19)

(11) Veröffentlichungsnummer: **0 416 145 A1**

## (12) EUROPÄISCHE PATENTANMELDUNG

(21) Anmeldenummer: 89116383.4

(22) Anmeldetag: 05.09.89

(51) Int. Cl.⁵: **H03K 3/03**, H03K 3/354

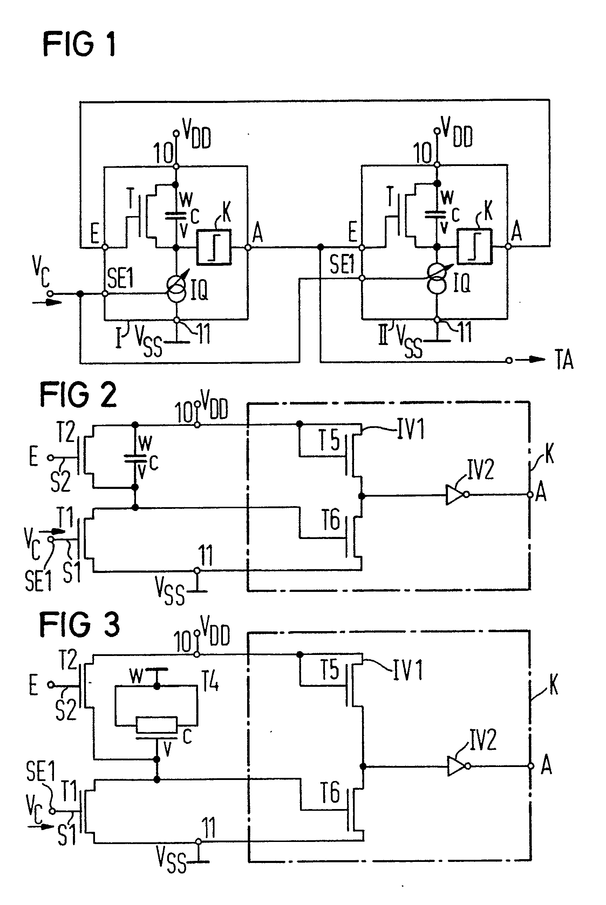

Ein Antrag gemäss Regel 88 EPÜ auf Berichtigung der Figur 1 liegt vor. Über diesen Antrag wird im Laufe des Verfahrens vor der Prüfungsabteilung eine Entscheidung getroffen werden (Richtlinien für die Prüfung im EPA, A-V, 2.2).

(43) Veröffentlichungstag der Anmeldung:
**13.03.91 Patentblatt 91/11**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**W-8000 München 2(DE)**

(72) Erfinder: **Langenkamp, Ulrich, Dipl.-Ing.**
**Jacobistrasse 15**
**W-7800 Freiburg(DE)**

(54) Schaltungsanordnung für einen integrierbaren und steuerbaren Ringoszillator.

(57) Um ein möglichst symmetrisches Taktsignal zu erzeugen, wird ein zweistufiger Ringoszillator vorgeschlagen, dessen Stufen (I, II) in ihrer Verzögerungszeit durch Umladen einer Kapazität (C) mittels einer Stromquelle (IQ) einstellbar sind. Die Stromquelle (IQ) wird dazu über einen Steuereingang (SE1) von einem Steuerstrom beaufschlagt, der die Verzögerungszeit bestimmt.

FIG 1

## SCHALTUNGSANORDNUNG FÜR EINEN INTEGRIERBAREN UND STEUERBAREN RINGOSZILLATOR

Die Erfindung betrifft eine Schaltungsanordnung für einen integrierbaren und steuerbaren Ringoszillator nach dem Oberbegriff des Anspruchs 1.

Steuerbare Oszillatoren sind allgemein bekannt und werden bevorzugt in Phasenregelkreisen (PLL) eingesetzt (vgl. dazu beispielsweise Tietze, Schenk: Halbleiter-Schaltungstechnik, 5. Auflage, 1980, S. 701 bis 703). Die steuerbaren Oszillatoren können sowohl spannungsgesteuert (VCO) als auch stromgesteuert (ICO) werden. Solche steuerbaren Oszillatoren werden beispielsweise als Ringoszillator oder bistabile Kippstufen realisiert, bei denen die Zeitkonstanten durch RC-Kombinationen eingestellt werden. Der Widerstand ·R ist dabei über eine Steuerspannung variabel.

Ein spannungsgesteuerter Ringoszillator mit RC-Zeitkonstanten ist beispielsweise aus Electronics Letters, 1986, Vol. 22, No. 12, S. 677 bis 679 bekannt. Der dort in FIG 1 dargestellte Ringoszillator weist eine ungerade Anzahl hintereinander geschalteter Inverterstufen auf, wobei vor jede Inverterstufe ein mit seinem Steueranschluß an eine gemeinsame Steuerleitung angeschlossener MOS-FET vorgesehen ist, der als steuerbarer Widerstand wirkt und die RC-Zeitkonstante steuert. C ist die Eingangsimpedanz jedes Inverters. Der Ausgang der letzten Inverterstufe ist auf die Laststrecke des ersten FET rückgekoppelt. Die Frequenz des am Ringoszillator abgreifbaren Taktsignales ist von der an den MOS-FETs anliegenden Steuerspannung abhängig.

Um den Frequenzbereich des Phasenregelkreises in allen Betriebszuständen vom Steuerbereich des steuerbaren Oszillators abzudecken, ist es wegen des Einflusses von Herstellungstoleranzen oder Temperaturabhängigkeiten notwendig, den Steuerbereich des steuerbaren Oszillators oft deutlich größer zu wählen als den Arbeitsbereich des Phasenregelkreises. Dadurch erhöht sich jedoch die Regelsteilheit, was zwangsweise zu einem schlechteren Regelverhalten und damit zu einem höheren Filteraufwand führt. Ungünstig wirkt sich auch eine nicht lineare Kennlinie des steuerbaren Oszillators aus. Steht aufgrund der Herstellungstoleranzen, Temperaturabhängigkeit oder der nicht linearen Kennlinie am Ausgang des steuerbaren Oszillators nur ein unsymmetrisches Ausgangssignal zur Verfügung, also ein Ausgangssignal, dessen Puls-Pausen-Verhältnis ungleich 1 ist, so kann die Weiterverarbeitung des Taktsignales problematisch werden. Ist mit dem steuerbaren Oszillator jedoch nur ein unsymmetrisches Ausgangssignal zu erreichen, so ist es möglich, den steuerbaren Oszillator auf der doppelten Frequenz schwingen zu lassen und anschließend in einer Frequenzteilerstufe dieses Ausgangssignal um den Faktor 2 herunterzuteilen, um damit eine Symmetrierung des Ausgangssignals des steuerbaren Oszillators zu bewirken.

Diese Lösung wird besonders dann problematisch, wenn - je nach verwendeter Herstellungstechnologie des im allgemeinen integrierten Schaltkreises - das Schaltverhalten durch parasitäre Komponenten des steuerbaren Oszillators wesentlich mitbestimmt wird.

Bei den eingangs erwähnten Ringsoszillatoren oder bistabilen Kippstufen ist die Frequenz des an deren Ausgang abgreifbaren Taktsignales von der an den Steueranschlüssen der MOS-Transistoren angelegten Steuerspannung abhängig. Änderungen der Schwellspannung, der Beweglichkeit der Ladungsträger und der Geometrie der Transistoren infolge von Herstellungstoleranzen und/oder Temperaturabhängigkeiten beeinflussen jedoch die Frequenz des Taktsignales, was selbstverständlich unerwünscht ist.

Eine weitere Möglichkeit, gesteuerte Oszillatoren zu realisieren, besteht beispeilsweise in CMOS-Technologie darin, daß mit Hilfe eines Stromspiegels eine Kapazität gleichmäßig aufgeladen und entladen wird. In Verbindung mit einem Hysterese-Inverter, also einer Schmitt-Trigger-Stufe, kann damit ein symmetrisches Taktsignal erzeugt werden. Bei dieser Art von steuerbaren Oszillatoren entstehen jedoch Toleranzprobleme dadurch, daß die Oszillator-Frequenz von der Größe der Hysterese linear abhängig ist.

Der Erfindung liegt die Aufgabe zugrunde, eine Schaltungsanordnung für einen einfach zu realisierenden Ringoszillator mit linearer Kennlinie anzugeben, dessen Ausgangstaktsignal ein möglichst symmetrisches Puls-Pausen-Verhältnis aufweist. Eine Frequenzteilerstufe soll bei der Schaltungsanordnung vermieden werden.

Diese erfindungsgemäße Aufgabe wird durch die kennzeichnenden Merkmale des Anspruchs 1 gelöst.

Weiterbildungen der Erfindung sind Gegenstand der Unteransprüche.

Die erfindungsgemäße Schaltungsanordnung für eine Ringoszillator beruht also im wesentlichen darauf, daß das Umladen der in den beiden Stufen vorhandenen Kapazitäten mit einem definierten Strom kontrolliert wird. Bei der erfindungsgemäßen Schaltungsanordnung für einen Ringoszillator ist es besonders vorteilhaft, daß die Kapazitäten und Ströme gut reproduzierbare Größen sind und nur geringe Toleranzen und eine geringe Temperaturabhängigkeit zeigen. Damit wird eine gute Anpassung des Steuerbereichs des Ringoszillators an den vom Phasenregelkreis geforderten Bereich erreicht.

Die Erfindung wird im folgenden anhand von fünf Figuren eingehend erläutert. Es zeigen:

FIG 1 ein Prinzipschaltbild einer erfindungsgemäßen Schaltungsanordnung für einen zweistufigen Ringoszillator,

FIG 2 ein erstes Ausführungsbeispiel für eine Schaltungsanordnung einer Stufe mit an positives Potential gelegter Kapazität,

FIG 3 ein Zweites Ausführungsbeispiel für eine Schaltungsanordnung einer Stufe mit an Bezugspotential gelegter Kapazität,

FIG 4 ein Ausführungsbeispiel für eine detaillierte Schaltungsanordnung eines Ringoszillators nach der Erfindung mit spannungsgesteuerter Stromquelle zur Einstellung der Frequenz des am Ringoszillator abgreifbaren Taktsignales und

FIG 5 eine zeitlichen Verlauf der in der Schaltungsanordnung nach FIG 4 auftretenden Spannungen.

In FIG 1 ist das Prinzipschaltbild der erfindungsgemäßen Schaltungsanordnung für einen Ringoszillator dargestellt. Der Ringoszillator weist zwei hintereinander geschaltete Stufen I, II auf, die beide zwischen zwei Versorgungsklemmen 10, 11, an denen positives Potential $V_{DD}$ und Bezugspotential $V_{SS}$ anliegen, angeschlossen sind. Die Ausgangsklemme A der ersten Stufe I ist mit der Eingangsklemme E der zweiten Stufe II verbunden. Die Ausgangsklemme A der zweiten Stufe II ist über einen Invertierer 1 àn die Eingangsklemme E der ersten Stufe I angeschlossen. Jede der beiden Stufen I, II weist einen Steuereingang SE1 auf, die beide von einer Steuergröße $V_C$ beaufschlagbar sind um das an der Eingangsklemme E der zweiten Stufe II abgreifbare Ausgangstaktsignal TA des Ringoszilators in der Frequenz zu variieren.

Jede der beiden Stufen I, II weist prinzipiell eine zwischen die Versorgungsklemmen 10 und 11 geschaltete Reihenschaltung einer nach Maßgabe der am Steuereingang SE1 anliegenden Steuergröße $V_C$ steuerbaren Stromquelle IQ mit einer Laststrecke eines Transistors T auf, dessen Steueranschluß mit der Eingangsklemme E der betreffenden Stufe I, II verbunden ist. Wie in FIG 1 weiterhin dargestellt ist, ist zwischen die Ausgangsklemme A jeder der Stufen I, II und dem Verbindungspunkt von Stromquelle IQ und Transistor T eine Auskoppelstufe K geschaltet. Weiterhin weist jede der Stufen I, II eine Kapazität C auf, die mit ihrer einen Klemme v an den Verbindungspunkt zwischen Transistor T und Stromquelle IQ geschaltet und mit ihrer anderen Klemme w an festes Potential geschaltet ist. Mögliche schaltungstechnische Ausgestaltungen dieser Stufen I, II werden anhand der Folgenden FIG 2 und 3 näher erläutert.

In FIG 2 ist ein mögliches Ausführungsbeispiel einer schaltungstechnischen Realisierung der Stufen I, II dargestellt mit an positives Potential $V_{DD}$ geschalteter Kapazität C. Die Schaltungsanordnung in FIG 2 weist im einzelnen eine Reihenschaltung von Laststrecken eines ersten Transistors T1 mit einem zweiten Transistor T2 auf, die zwischen die VErsorgungsklemmen 10 und 11 geschaltet ist. Der Steueranschluß S1 des auf Bezugspotential $V_{SS}$ geschalteten ersten Transistors T1 ist mit der Steuereingangsklemme SE1 in Verbindung, während der Steueranschluß S2 des zweiten Transistors T2 an die Eingangsklemme E geschaltet ist. Eine Kapazität C ist parallel zur Laststrecke des zweiten Transistors T2 geschaltet. Der Verbindungspunkt des ersten Transistors T1 und zweiten Transitors T2 ist mit dem Eingang einer aus zwei weiteren Transistoren T5, T6 bestehenden Inverterstufe IV1 in Verbindung. Der Ausgang dieser Inverterstufe ist über eine weitere Inverterstufe IV2 an die Ausgangsklemme A angeschlossen.

Ein zweites Ausführungsbeispiel für eine schaltungstechnische Realisierung der Stufe I oder II ist in FIG 3 zu erkennen. Die bisher bekannten Bezugszeichen werden für gleiche Teile Weiterverwendet. Dieses Ausführungsbeispiel unterscheidet sich lediglich von FIG 2 dadurch, daß jetzt die kapazität C mit ihrer nicht am Verbindungspunkt zwischen dem ersten Transistor T1 und zweitem Transistor T2 liegenden Klemme w auf Bezugspotential $V_{SS}$ liegt. Die Kapazität C ist in diesem Ausführungsbeispiel durch einen Depletion-MOS-FET gebildet, dessen Steueranschluß an den Verbindungspunkt des ersten Transistors T1 und zweiten Transistors T2 angeschlossen ist und dessen Laststrecke kurzgeschlossen ist und mit Bezugspotential $V_{SS}$ in Verbindung steht.

Es ist hier noch anzumerken, daß die erste Stufe I und zweite Stufe II gleich ausgebildet werden müssen. Das bedeutet, daß die erste Stufe I und zweite Stufe II des Ringoszillators entweder beide die in FIG 2 dargestellte Schaltungsanordnung oder beide die in FIG 3 gezeigte Schaltungsanordnung aufweisen müssen. Ein wesentlicher Vorteil der erfindungsgemäßen Ausbildung der Schaltstufen I, II besteht darin, daß gleichartige Enhancement-MOS-FET verwendet werden können, deren Schwellspannungsänderungen sich nur wenig auf die Verzögerungszeit der Stufen I, II auswirken. Auch eine Veränderung der Versorgungsspannung wirkt sich kaum aus, da sich bei entsprechender Dimensionierung der Auskoppelstufe K deren Schaltschwelle verändert und einer Änderung der Versorgungsspannung kompensierend entgegenwirkt.

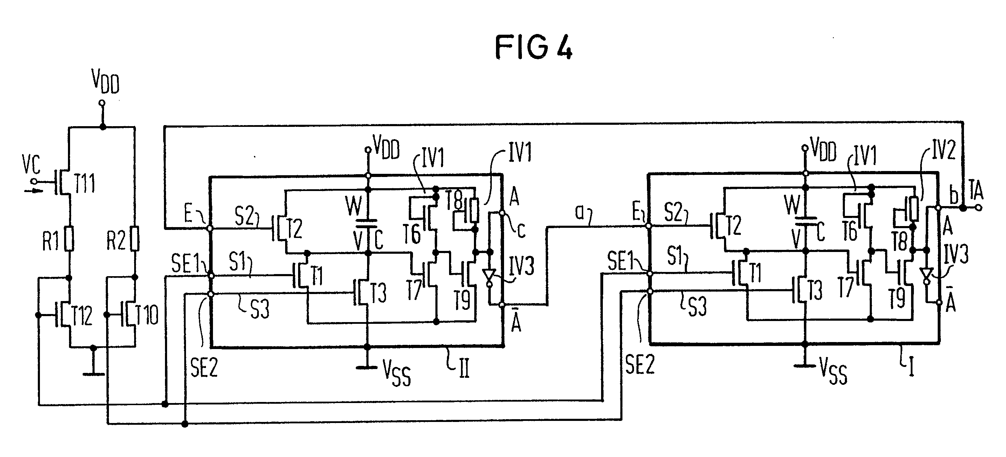

In der nachfolgenden FIG 4 wird eine Schaltungsanordnung für einen Ringoszillator nach der Erfindung mit spannungsgesteuerter Stromquelle zum Einstellen der Ausgangsfrequenz des Taktsignales TA vorgestellt. Die bekannten Bezugszeichen werden für gleiche Teile weiterverwendet. Jede der beiden Stufen I und II ist beispielsweise nach der in FIG 2 vorgestellten Schaltungsanordnung ausgebildet. Die zweite Inverterstufe IV2 besteht jetzt aus zwei in Reihe geschalteten Transistoren T8 und T9, wobei der an positives Potential $V_{DD}$ geschaltete Transistor T8 als Depletion-MOS-FET ausgebildet ist. Die anderen Transistoren T1, T2, T3, T6, T7, T9 sind Enhancement-MOS-FET. Der Verbindungspunkt der beiden Transistoren T6 und T7 ist mit dem Steueranschluß des Transistors T9 in Verbindung. Der Ausgang der zweiten Inverterstufe IV2 ist in diesem Ausführungsbeispiel sowohl mit der Ausgangsklemme A der betreffenden Stufe I, II in Verbindung als auch über eine dritte Inverterstufe IV3 mit einer invertierenden Ausgangsklemme $\overline{A}$. Im Gegensatz zu der in FIG 2 dargestellten Ausbildung der Stufen I, II ist jetzt parallel zum ersten Transistor T1 ein weiterer Transistors T3 geschaltet, dessen Steueranschluß S3 mit einem zweiten Steuereingang SE2 in Verbindung steht. Der Steueranschluß S1 des ersten Transistors T1 ist mit der ersten Steuereingangsklemme SE1 in Verbindung. Durch diese beiden Transistoren T1 und T3 wird der Steuerstrom, der die Frequenz des Ausgangstaktsignales des Ringsoszillators bestimmt, in eine variable und eine konstante Komponente aufgespaltet. Dazu ist die zweite Steuereingangsklemme SE2 an den Verbindungspunkt eines Spannungsteilers, der aus der Reihenschaltung eines Widerstandes R2 und eines als Widerstand geschalteten Transistors T10 besteht, geschaltet. Die Reihenschaltung aus dem Widerstand R2 und dem Transistor T10 liegt an $V_{DD}$ und $V_{SS}$. Der variable Steuerstrom wird der ersten Steuereingangsklemme SE1 zugeführt. Dazu weist die Schaltungsanordnung beispielsweise eine zwischen $V_{DD}$ und $V_{SS}$ angeordnete Reihenschaltung eines weiteren Transistors T11 mit einem Widerstand R1 und einem weiteren Transistor T12 auf. Dem Steueranschluß des Transistors T10 wird eine Steuerspannung $V_C$, die beispielsweise aus der PLL abgeleitet wird, zugeführt.

Durch die erfindungsgemäße Ausführung der Schaltungsanordnung nach FIG 4 besteht die Möglichkeit, Schwankungen der Versorgungsspannung auszugleichen, indem - wie gezeigt - der Steuerstrom in eine variable und eine konstante Komponente aufgespaltet wird. Wird die konstante Komponente aus der Versorgungsspannung abgeleitet, so führt eine Erhöhung der Versorgungsspannung zu einer Erhöhung des Steuerstroms und umgekehrt. Dadurch kann eine Änderung der Verzögerungszeiten in den Stufen durch Änderungen der Versorgungsspannung wirksam vermieden werden. Im allgemeinen sind die Steuereingänge SE1, SE2 jeder Stufe I, II Bestandteile einer Stromspiegelschaltung, mit der ein Steuerstrom die Stromquellen der CI-Zeitkonstanten steuert. Falls anstelle eines Steuerstroms eine Steuerspannung zur Verfügung steht, wie dies in FIG 4 der Fall ist, kann diese durch einen Strom/Spannungswandler in einen Steuerstrom gewandelt werden.

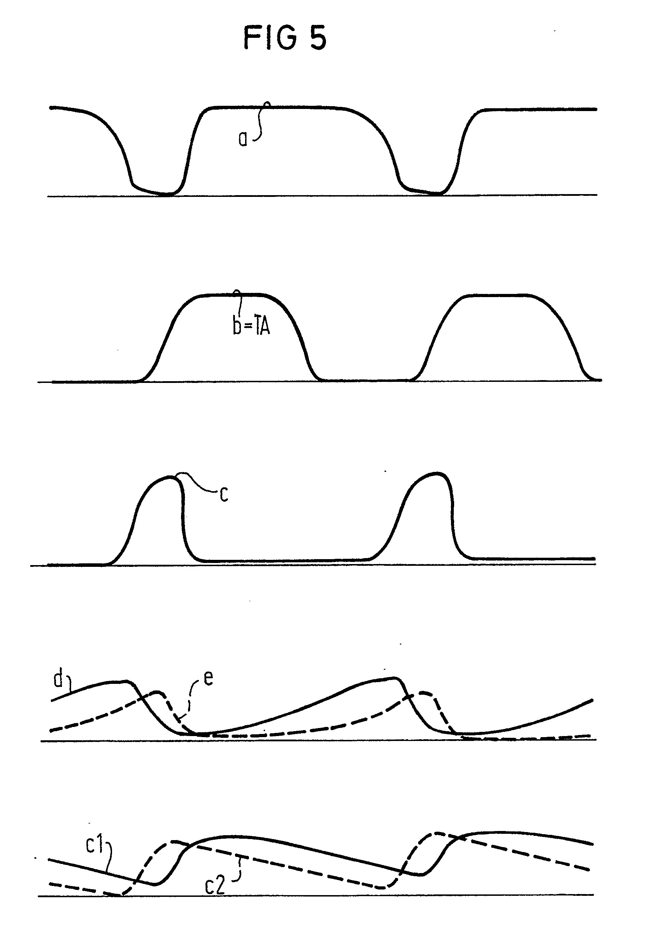

In FIG 5 ist der zu FIG 4 gehörende Signalverlauf für eine Taktfrequenz von 14,7 Mhz dargestellt. Mit a ist das Signal an der Eingangsklemme E der ersten Stufe I bezeichnet, an deren Ausgangsklemme A das mit b gekennzeichnete Taktsignal abgreifbar ist. Dieses mit b bezeichnete Taktsignal ist zugleich das Ausgangssignal TA des Ringoszillators, das auf die Eingangsklemme E der zweiten Stufe II rückgekoppelt wird. An der Ausgangsklemme A dieser zweiten Stufe II liegt das mit c gekennzeichnete Signal an. Das zu c invertierte Signal ist an der Ausgangsklemme $\overline{A}$ der zweiten Stufe II abgreifbar und entspricht dem Signalverlauf von a. Das Laden und Entladen der in der ersten Stufe I vorhandenen Kapazität C ist mit C1 und in der zweiten Stufe II mit C2 gekennzeichnet. Die Ausgangsspannung der ersten Inverterstufe IV1 in der ersten Stufe I ist mit d gekennzeichnet, während die Ausgangsspannung der ersten Inverterstufe IV1 in der zweiten Stufe II mit e gekennzeichnet ist. Es ist deutlich zu erkennen, daß die Schaltungsanordnung für den erfindungsgemäßen Ringoszillator ein sehr symmetrisches Ausgangssignal aufweist. Wie aus FIG 5 ersichtlich, ist es notwendig, daß die Kapazität im Vergleich zur Ladezeit sehr schnell entladen wird. Dies ist deshalb notwendig, da der Entladevorgang bei der in FIG 2 und 4 gezeigten Anordnung von der Temperatur und den Herstellungstoleranzen abhängig ist. Wird die Entladezeit so kurz wie möglich gehalten, können die Toleranzen der Entladezeit die Frequenz des Taktsignales des Ringoszillators nur wenig beeinflussen. Die im Gegensatz zur Entladezeit längere Ladezeit ist vom Stromspiegel kontrollierbar. Die Ladezeit der Kapazität bestimmt die Frequenz des Taktsignales des Ringoszillators.

Bei der Schaltungsanordnung nach FIG 3, bei der die Kapazität auf Bezugspotential liegt, muß dagegen die Ladezeit so kurz wie möglich sein, damit Toleranzen in der Ladezeit die Frequenz des Taktsignales des Ringoszillators nur wenig beeinflußt. Bei der in FIG 3 vorgestellten Schaltungsanordnung wird die Entladung der Kapazität durch den Stromspiegel kontrolliert.

Mit der erfindungsgemäßen Schaltungsanordnung für einen Ringoszillator kann ein steuerbarer Oszillator mit geringen Toleranzen aufgebaut werden, der ein Taktsignal mit symmetrischen Puls-Pausen-Verhältnis zur Verfügung stellt. Die erfindungsgemäße Schaltungsanordnung ist besonders zur Realisierung in MOS-Technologie und insbesondere in NMOS-Technologie geeignet. Wenn NMOS-Technologie verwendet wird, können Lade-
und Entlade ströme aufgrund von Toleranzen erheblich voneinander abweichen. Da in der vorgestellten Schaltungsanordnung jedoch nur die Ladeströme oder Entladeströme zur Einstellung der
Taktfrequenz des Ringoszillators verwendet werden, sind diese Toleranzen unerheblich. Ein symmetrisches Ausgangssignal des Taktes ist damit
auch in NMOS-Technologie realisierbar.


Bezugszeichenliste

I erste Stufe
II zweite Stufe
1 Invertierer
10, 11 Versorgungsspannungsquellen einer Stufe
A Ausgangsklemme einer Stufe
$\overline{A}$ invertierende Ausgangsklemme einer Stufe
C Kapazität einer Stufe
E Eingangsklemme einer Stufe
IV1 erste Inverterstufe
IV2 zweite Inverterstufe
IV3 dritte Inverterstufe
IQ steuerbare Stromquelle einer Stufe
K Auskoppelstufe einer Stufe
R1, R2 Widerstände
S1 Steueranschluß des ersten Transistors
S2 Steueranschluß des zweiten Transistors
S3 Steueranschluß des dritten Transistors
SE1 erster Steuereingang einer Stufe
SE2 zweiter Steuereingang einer Stufe
T Transistor einer Stufe
TA Ausgangstaktsignal
T1 erster Transistor
T2 zweiter Transistor
T3 dritter Transistor
T6, T7 Transistoren der ersten Inverterstufe
T8, T9 Transistoren der zweiten Inverterstufe
T10, T11, T12 weitere Transistoren
$V_C$ Steuergröße
$V_{DD}$ positives Potential
$V_{SS}$ Bezugspotential
a Signal an der Eingangsklemme E des Ringoszillators
b Signal an der Ausgangsklemme A der ersten
Stufe I
c Signal an der Ausgangsklemme A der zweiten
Stufe II
C1 Umladen der Kapazität in der ersten Stufe I
c2 Umladen der Kapazität in der zweiten Stufe II
d Ausgangsspannung der ersten Inverterstufe
IV1 in der ersten Stufe I
e Ausgangsspannung der ersten Inverterstufe
IV1 in der zweiten Stufe II
v eine Klemme der Kapazität C
w andere Klemme der Kapazität C

## Ansprüche

1. Schaltungsanordnung für einen integrierbaren
und steuerbaren Ringoszillator zum Erzeugen eines
Taktsignales (TA) mit einer ersten Stufe (I), an
deren Ausgangsklemme (A) eine Eingangsklemme
(E) einer zweiten Stufe (II) geschaltet ist, wobei
beide Stufen (I, II) zwischen Versorgungsklemmen
(10, 11) geschaltet sind, **dadurch gekennzeichnet,**
daß ein Invertierer (1) zwischen die Ausgangsklemme (A) der zweiten Stufe (II) und Eingangsklemme
(E) der ersten Stufe (I) geschaltet ist,
daß das Taktsignal (TA) an der Eingangsklemme
(E) der zeiten Stufe (II) abgreifbar ist,
daß jede Stufe (I, II) mindestens aufweist:
- eine zwischen die Versorgungsklemmen (10, 11)
geschaltete Reihenschaltung einer Laststrecke eines die Frequenz des Taktsignales (TA) bestimmenden und nach Maßgabe einer Steuergröße (Vc)
steuerbaren und als Stromquelle wirkenden ersten
Transistor (T1) mit einer Laststrecke eines zweiten
Transistors (T2), dessen Steueranschluß (S2) mit
der Eingangsklemme (E) verbunden ist,
- eine Kapazität (C), die mit ihrer einen Klemme (v)
an den Verbindungspunkt zwischen ersten Transistor (T1) und zweiten Transistor (T2) und mit ihrer
anderen Klemme (w) an ein festes Potential geschaltet ist sowie
- eine zwischen die Ausgangsklemme (A) und den
Verbindungspunkt geschaltete Auskoppelstufe (K).
2. Schaltungsanordnung nach Anspruch 1, **dadurch gekennzeichnet, daß** in jeder der Stufen (I,
II) der zweite Transistor (T2) sowie die andere
Klemme (w) der Kapazität (C) mit der an positives
Potential ($V_{DD}$) zu legenden Versorgungsklemme
(10) verbunden ist.
3. Schaltungsanordnung nach Anspruch 1, **dadurch gekennzeichnet, daß** in jeder der Stufen (I,
II) der zweite Transistor (T2) mit der an positives
Potential ($V_{DD}$) zu legenden Versorgungsklemme
(10) und die andere Klemme (w) der Kapazität (C)
mit der an Bezugspotential ($V_{SS}$) zu legenden Versorgungsklemme (11) verbunden ist.
4. Schaltungsanordnung nach einem der Ansprüche 1 bis 3,
**dadurch gekennzeichnet, daß** jede Stufe (I, II)
eine Steuereingangsklemme (SE1) aufweist, die mit
einem Steueranschluß (S1) des in der Stufe (I, II)
angeordnetes ersten Transistors (T1) verbunden
ist, wobei die Steuereingangsklemmen (SE1) der
beiden Stufen (I, II) von der gleichen Steuergröße
(Vc) beaufschlagbar sind.
5. Schaltungsanordnung nach Anspruch 4, **dadurch gekennzeichnet, daß** als Steuergröße (Vc)
ein Steuerstrom oder eine Steuerspannung vorgesehen ist.
6. Schaltungsanordnung nach einem der Ansprüche 1 bis 5, **dadurch gekennzeichnet,** daß die Auskoppelstufe (K) mindestens eine zwischen den Versorgungsklemmen (10, 11) liegende Inverterstufe (IV1, IV2, IV3) aufweist.

7. Schaltungsanordnung nach einem der Ansprüche 1 bis 6, **dadurch gekennzeichnet,** daß ein parallel zum ersten Transistor (T1) geschalteter dritter Transistor (T3) vorgesehen ist, dessen Steueranschluß (S3) mit einer zweiten Steuereingangsklemme (SE2) verbunden und von einer der Versorgungsspannung des Ringoszillators abhängigen Größe beaufschlagbar ist.

8. Schaltungsanordung nach einem der Ansprüche 1 bist 7, **dadurch gekennzeichnet,** daß die Kapazität (C) durch einen MOS-Transistor (T4) gebildet ist, dessen Steueranschluß (S4) die eine Klemme (v) und dessen kurzgeschlossene Laststrecke die andere Klemme (w) der Kapazität (C) bildet.

9. Schaltungsanordnung nach einem der Ansprüche 1 bis 8, **gekennzeichnet** durch die Verwendung von NMOS-Transistoren.

10. Schaltungsanordnung nach einem der Ansprüche 1 bis 9, **gekennzeichnet** durch die Integration auf einem Halbleiter-Körper.

**FIG 1**

**FIG 2**

**FIG 3**

FIG 4

EP 0 416 145 A1

# FIG 5

Europäisches Patentamt

**EUROPÄISCHER RECHERCHENBERICHT**

Nummer der Anmeldung

EP 89 11 6383

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | US-A-3 708 757 (SAVARESE et al.) * Spalte 4, Zeile 47 - Spalte 7; Figuren 2,4 * | 1,3,4,5 ,6,10 | H 03 K 3/03 H 03 K 3/354 |
| Y | | 2,7,8 | |
| Y | WIRELESS WORLD, Band 77, Nr. 1434, Dezember 1971, Seiten 604-605, Haywards Heath, GB; J.B. CAIRNS: "Linear ramp generator" * Figur 3 * | 2 | |
| Y | EP-A-0 322 047 (PHILIPS ELECTRONIC AND ASSOCIATED IND. LTD) * Spalte 7, Zeile 28 - Spalte 9, Zeile 4; Figur 6 * | 7 | |
| Y | EP-A-0 144 636 (IBM) * Seite 26, Anspruch 4; Figuren 3A,3B * | 8 | |
| A | EP-A-0 243 878 (SIEMENS) * Zusammenfassung; Figur 2 * | 9 | |

RECHERCHIERTE SACHGEBIETE (Int. Cl.5)

H 03 K

Der vorliegende Recherchenbericht wurde für alle Patentansprüche erstellt

| Recherchenort | Abschlußdatum der Recherche | Prüfer |
|---|---|---|
| DEN HAAG | 27-04-1990 | CANTARELLI R.J.H. |